Europäisches Patentamt

European Patent Office

Office européen des brevets

(19)

(11) **EP 0 564 341 B1**

(12) **FASCICULE DE BREVET EUROPEEN**

(45) Date de publication et mention
de la délivrance du brevet:
**25.11.1998   Bulletin 1998/48**

(51) Int Cl.6: **H03G 1/00**, H03F 3/45

(21) Numéro de dépôt: **93400800.4**

(22) Date de dépôt: **29.03.1993**

(54) **Circuit amplificateur vidéo à commande de gain et d'alignement**

Videoverstärker mit Verstärkungs- und Ausrichtsteuerung

Video amplifier with gain and alignment control

(84) Etats contractants désignés:
**DE FR GB IT**

(30) Priorité: **01.04.1992 FR 9203951**

(43) Date de publication de la demande:
**06.10.1993   Bulletin 1993/40**

(73) Titulaire: **SGS-THOMSON MICROELECTRONICS
S.A.
94250 Gentilly (FR)**

(72) Inventeurs:
• **Samani, Davood
F-38950 St Martin le Vinoux (FR)**
• **Gerot, Guy
F-92000 Nanterre (FR)**
• **Douche, Jean-Louis
F-38330 Biviers (FR)**

(74) Mandataire: **Schmit, Christian Norbert Marie et al
Cabinet Ballot-Schmit
7, rue Le Sueur
75116 Paris (FR)**

(56) Documents cités:
GB-A- 2 013 431          US-A- 3 512 096
US-A- 3 727 146          US-A- 4 471 320

# Description

La présente invention concerne un circuit amplificateur vidéo à commande de gain et d'alignement, pour transformer un signal d'entrée en un signal de sortie ayant une valeur moyenne égale à une tension de consigne et des variations amplifiées par rapport aux variations du signal d'entrée avec un gain commandé par un signal de commande de gain.

Ce circuit a une application particulière dans la mise en forme de signaux de télévision, par exemple à la norme D2MAC, destinés à être traités numériquement pour produire une image de télévision. Un tel signal de télévision inclut habituellement des séquences de référence permettant de situer les valeurs du signal qui peuvent varier entre un niveau minimum, dit "niveau de noir", et un niveau maximum, dit "niveau de blanc". Pour optimiser la définition de l'image, on souhaite que ce signal analogique soit amplifié de façon que l'intervalle entre les niveaux minimum et maximum couvre sensiblement la pleine échelle des convertisseurs analogique/numérique qui transforment le signal en données numériques à traiter. Ceci nécessite d'une part une amplification avec un gain commandé en fonction de l'amplitude du signal d'entrée, cette amplitude pouvant varier du fait de la source du signal ou de ses conditions de transmission, et d'autre part un réglage de niveau destiné à aligner le signal amplifié par rapport aux seuils des convertisseurs analogique/numérique.

Pour aligner le signal, on utilise habituellement une technique de verrouillage (clamp), technique de "pincement", dans laquelle le signal passe par un condensateur qui est chargé sous une tension de verrouillage incluse dans une séquence de référence identifiable de chaque ligne du signal d'entrée. Le condensateur est chargé pendant la séquence de référence et doit conserver une charge constante pendant le reste de la ligne. Cette condition est très difficile à remplir de façon satisfaisante lorsque la séquence de référence est très courte par rapport à la durée d'une ligne, ce qui est le cas notamment pour les signaux à la norme D2MAC pour lesquels une ligne dure 64µs et inclut une séquence de référence d'environ 750 ns.

Les présents inventeurs ont adopté une approche consistant à commander la valeur moyenne du signal de sortie et le gain d'amplification. Ces deux grandeurs sont déterminées par les processeurs numériques qui analysent le signal de sortie du circuit. La valeur moyenne à appliquer dépend du contenu de l'image à présenter, plus précisément de la proportion de blanc dans l'image. Le gain à appliquer dépend de l'amplitude des variations du signal d'entrée entre les niveaux minimum et maximum, qui est indépendante du contenu de l'image.

Pour commander la valeur moyenne d'un signal, on connaît une technique de compensation par boucle en continu dans laquelle on échantillonne périodiquement le signal pour produire une tension d'erreur en cas de dérive par rapport à la tension de consigne, une boucle de contre-réaction agissant pour ajouter une composante continue adaptée lorsqu'une dérive est détectée. Lorsque la commande d'alignement par boucle en continu a lieu avant l'amplification, la tension de consigne doit dépendre du gain d'amplification et donc de l'amplitude du signal d'entrée alors que la tension d'erreur en est indépendante, ce qui est inacceptable. Lorsqu'on réalise d'abord l'amplification à gain commandé, puis la commande d'alignement par boucle en continu, on rend certes indépendantes les deux commandes, mais la variation de la valeur moyenne du signal d'entrée par rapport à la tension d'alimentation du circuit provoque des phénomènes de blocage et de saturation inacceptables.

Le but de la présente invention est de proposer un amplificateur vidéo à commande de gain et d'alignement permettant de commander indépendamment la valeur moyenne du signal de sortie et le gain d'amplification.

L'invention propose ainsi un circuit amplificateur vidéo à commande de gain et d'alignement, pour transformer un signal d'entrée en un signal de sortie ayant une valeur moyenne égale à une tension de consigne et des variations amplifiées par rapport aux variations du signal d'entrée avec un gain commandé par un signal de commande de gain, caractérisé en ce qu'il comprend un premier étage et un second étage sensiblement identique au premier étage, en ce que chacun de ces deux étages comprend respectivement un point d'entrée et un point de sortie et est agencé pour produire à son point de sortie respectif une tension ayant une valeur moyenne réglable et des variations amplifiées par rapport aux variations de la tension à son point d'entrée respectif avec le gain commandé par le signal de commande de gain, en ce que le point d'entrée du premier étage est relié à un condensateur de découplage recevant le signal d'entrée, en ce que le point de sortie du premier étage fournit le signal de sortie du circuit, et en ce que le circuit comprend en outre un comparateur ayant une entrée reliée au point de sortie du second étage et une entrée recevant la tension de consigne, ce comparateur répondant à un écart entre la tension de consigne et la tension au point de sortie du second étage en produisant un signal de réglage d'alignement qui est adressé aux deux étages pour modifier identiquement la valeur moyenne de la tension aux points de sortie des deux étages, de manière à rendre la tension au point de sortie du second étage égale à la tension de consigne.

Les deux étages sont identiques, et seul le premier étage reçoit la composante variable du signal d'entrée, sa composante continue (valeur moyenne) étant éliminée par le condensateur de découplage. Par conséquent le point de sortie de second étage est à une tension qui reproduit la valeur moyenne de la tension au point de sortie du premier étage. Le comparateur reçoit des informations du second étage et agit en contre-réaction sur les deux étages, pour que la tension au point de sortie du second étage et donc la valeur moyenne de la tension au point de sortie du premier étage soient égales à la tension de consigne, quel que soit le gain commandé.

On obtient ainsi l'indépendance désirée entre les deux commandes sans observer de blocage ou de saturation inacceptable.

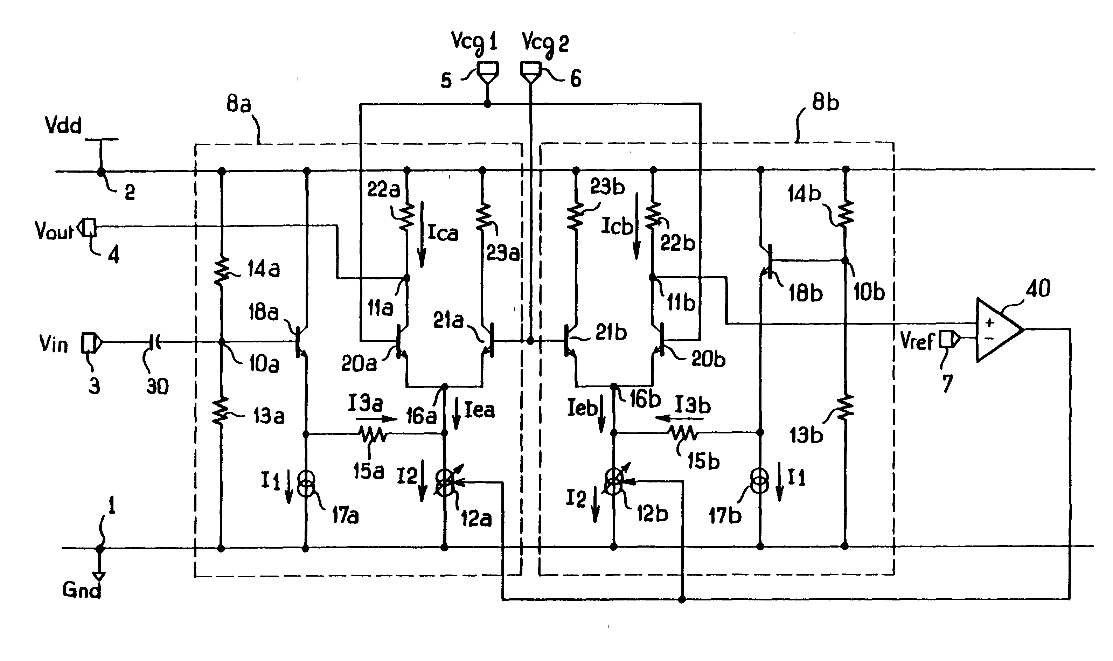

D'autres particularités et avantages de la présente invention apparaîtront dans la description ci-après d'un exemple de réalisation préféré et non limitatif, lue conjointement au dessin annexé, dans lequel la figure unique représente un schéma électrique d'un circuit amplificateur vidéo selon l'invention.

Le circuit préféré représenté à la figure comprend : une borne de masse 1 portée au potentiel de la masse Gnd, une borne d'alimentation 2 portée à une tension d'alimentation Vdd, par exemple de +5V ; une borne d'entrée 3 recevant le signal de tension d'entrée Vin à mettre en forme par le circuit ; une borne de sortie 4 délivrant le signal de tension de sortie mis en forme Vout ; deux bornes de commande de gain 5, 6 recevant un signal de commande de gain composé de deux tensions Vcg1, Vcg2 appliquées respectivement aux bornes 5, 6 ; et une borne de commande d'alignement 7 recevant une tension de consigne Vref.

Le circuit est conçu pour que le signal de sortie Vout ait une valeur moyenne égale à la tension de consigne Vref et des variations amplifiées par rapport à celles du signal d'entrée Vin avec un gain commandé par le signal de commande de gain Vcg1, Vcg2, plus précisément par la différence Vcg1 - Vcg2 entre les deux tensions de commande de gain.

Le circuit comprend un premier étage 8a et un second étage 8b identique au premier étage 8a. Dans la description ci-après, les symboles de référence se terminant par "a" désignent des composants du premier étage 8a, et ceux se terminant par "b" désignent des composants identiques du second étage 8b. Par "identique", on entend qu'à chaque composant du premier étage 8a correspond un composant du second étage 8b ayant sensiblement les mêmes caractéristiques électriques. Pour remplir cette condition, on peut réaliser le circuit sur une même puce de silicium en formant de façon classique, les composants correspondants des deux étages 8a, 8b (qui sont essentiellement des résistances et des transistors) au cours des mêmes étapes d'implantation de dopants.

Chacun des deux étages 8a, 8b comprend respectivement un point d'entrée 10a, 10b, un point de sortie 11a, 11b, de moyens de conversion tension/courant, un générateur de courant réglable 12a, 12b, et des moyens de multiplication de courant.

Pour chaque étage 8a, 8b, les moyens de conversion tension/courant comprennent respectivement une première résistance de polarisation 13a, 13b montée entre le point d'entrée 10a, 10b et borne de masse 1, une seconde résistance de polarisation 14a, 14b montée entre le point d'entrée 10a, 10b et la borne d'alimentation 2, et une résistance de conversion 15a, 15b ayant une première extrémité reliée à l'entrée 16a, 16b des moyens de multiplication de courant et une seconde extrémité reliée au point d'entrée 10a, 10b de l'étage par l'intermédiaire d'un tampon d'isolement. Le tampon d'isolement comprend un générateur de courant constant 17a, 17b et un transistor bipolaire npn 18a, 18b monté en émetteur suiveur. Le transistor 18a, 18b a son collecteur relié à la borne d'alimentation 2, sa base reliée au point d'entrée 10a, 10b de l'étage, et son émetteur relié à la seconde extrémité de la résistance de conversion 15a, 15b. Le générateur de courant constant 17a, 17b est monté entre la borne de masse 1 et l'émetteur du transistor 18a, 18b et délivre un courant I1, identique pour les deux étages, suffisant pour rendre conducteur la jonction base/émetteur du transistor 18a, 18b. Ainsi, les moyens de conversion tension/courant de chaque étage 8a, 8b produisent, à travers la résistance de conversion 15a, 15b, un courant I3a, I3b ayant des variations proportionnelles aux éventuelles variations de la tension V1a, V1b au point d'entrée 10a, 10b de l'étage. Dans le cas du second étage 8b, la tension V1b au point d'entrée 10b ne comporte pas de composante variable. Le courant I3b dans la résistance de conversion 15b est donc continu. Ce courant I3b a une valeur égale à la valeur moyenne du courant I3a dans la résistance de conversion 15a du premier étage 8a.

Le générateur de courant réglable 12a, 12b de chaque étage 8a, 8b est monté entre la borne de masse 1 et l'entrée 16a, 16b des moyens de multiplication de courant respectifs. Il délivre un courant réglable I2 identique pour les deux étages. Les moyens de multiplication de courant de chaque étage reçoivent donc à leur entrée une combinaison Iea = I2-I3a, Ieb = I2-I3b du courant I2 produit par le générateur de courant réglable 12a, 12b et du courant I3a, I3b produit par les moyens de conversion tension/courant.

Pour chaque étage 8a, 8b, les moyens de multiplication de courant sont de préférence réalisés sous la forme d'un amplificateur différentiel. Cet amplificateur comprend deux transistors bipolaires npn identiques 20a et 21a, 20b et 21b et deux résistances identiques 22a et 23a, 22b et 23b. Les résistances identiques 22a et 23a, 22b et 23b sont respectivement montées entre la borne d'alimentation 2 et les collecteurs des transistors 20a et 21a, 20b et 21b. Les transistors 20a et 21a, 20b et 21b ont leurs émetteurs respectifs reliés conjointement à l'entrée 16a, 16b des moyens de multiplication de courant. La base du transistor 20a, 20b est reliée à la borne de commande de gain 5 et reçoit donc la tension de commande de gain Vcg1. La base du transistor 21a, 21b est reliée à la borne de commande de gain 6 et reçoit donc la tension de commande de gain Vcg2. L'amplificateur ainsi agencé produit à travers la résistance 22a, 22b un courant Ica, Icb égal au courant Iea, Ieb reçu à l'entrée 16a, 16b de l'amplificateur, multipliée par un facteur k, compris entre 0 et 1, imposé par le signal de commande de gain Vcg1, Vcg2, plus précisément par la différence Vcg1 - Vcg2 entre les deux tensions de commande de gain.

Le point de sortie 11a, 11b de chaque étage 8a, 8b est directement relié au collecteur du transistor 20a, 20b. Le point de sortie 11a, 11b de chaque étage est ainsi disposé pour être à une tension V2a, V2b, ayant, par rapport au courant Ica, Icb produit par les moyens de multiplication de courant, une dépendance linéaire donnée par :

$$V2a = Vdd - R \times Ica$$

$$V2b = Vdd - R \times Icb$$

où R désigne la valeur ohmique des résistances 22a, 22b. Par conséquent, la tension V2a, V2b au point de sortie 11a, 11b de chaque étage a une valeur moyenne qui peut être réglée en modifiant le courant I2 delivré par le générateur de courant réglable 12a, 12b, et des variations amplifiées par rapport aux variations de la tension V1a, V1b au point d'entrée 10a, 10b de l'étage avec un gain g commandé par le signal de commande de gain Vcg1, Vcg2. Le gain g est donné par l'expression $g = k \times R/R3$, où R3 désigne la valeur ohmique de la résistance de conversion 15a, 15b de chaque étage. Le signal de commande de gain Vcg1, Vcg2 sera donc déterminé pour obtenir un facteur de multiplication k donnant le gain g désiré.

Le point de sortie 11a du premier étage 8a est relié à la borne de sortie 4 du circuit pour fournir un signal de sortie Vout correspondant à la tension V2a en ce point 11a.

Le point d'entrée 10a du premier étage 8a est relié à la borne d'entrée 3 du circuit par l'intermédiaire d'un condensateur de découplage 30. Le condensateur 30 filtre la composante continue du signal d'entrée Vin qu'il reçoit et communique au point d'entrée 10a du premier étage les variations du signal d'entrée Vin. Le condensateur 30 doit donc avoir une capacité C telle que la constante de temps $R1 \times R2 \times C/(R1 + R2)$ soit grande par rapport à l'échelle de temps des variations du signal d'entrée, R1 et R2 désignant respectivement les valeurs ohmiques des première et seconde résistances de polarisation 13a, 14a du premier étage. On pourra choisir typiquement une capacité C de l'ordre de quelques microfarads, et des résistances R1, R2 de l'ordre de quelques centaines d'ohms pour un signal d'entrée ayant une fréquence de l'ordre du mégahertz ou d'une dizaine de mégahertz.

La tension V1a au point d'entrée 10a du premier étage, qui est égale à la tension aux bornes de la résistance de conversion 15a du premier étage, est donnée par $V1a = VP + VA$, où $VP = Vdd \times R1/(R1 + R2)$ est une tension de polarisation constante et VA désigne la composante variable du signal d'entrée Vin. La tension V2a au point de sortie 11a du premier étage est donc donnée par :

$$V2a = VM + g \times VA$$

où $VM = Vdd + g \times (VP - Vbe) - R \times k \times I2$ représente la valeur moyenne de la tension V2a (Vbe désignant la tension de la jonction base/émetteur du transistor 18a). On voit que cette valeur moyenne peut être réglée en modifiant le courant I2 délivré par le générateur de courant réglable 12a.

Comme le second étage 8b ne reçoit pas de signal variable à son point d'entrée 10b, son point de sortie 11b est à une tension stable V2b égale à la valeur moyenne VM de la tension V2a au point de sortie du premier étage.

Pour fixer cette valeur de tension V2b = VM, le circuit comprend un comparateur 40 ayant une entrée positive reliée au point de sortie 11b du second étage 8b, et une entrée négative reliée à la borne de commande d'alignement 7 pour recevoir la tension de consigne Vref. Lorsqu'il existe un écart entre la tension V2b au point 11b et la tension de consigne Vref, le comparateur 40 répond en produisant un signal de réglage d'alignement Verr qui est adressé aux deux étages 8a, 8b pour modifier identiquement la valeur moyenne VM de la tension aux points de sortie 11a, 11b des deux étages.

Le comparateur 40 est de préférence réalisé sous la forme d'un amplificateur à fort gain à réponse rapide réalisé en technologie BICMOS, c'est-à-dire combinant des transistors bipolaires et des transistors CMOS (métal-oxyde-semiconducteur complémentaires). Un tel amplificateur opérationnel, connu en lui-même, peut avoir un temps de réponse d'environ 100 ns avec un faible courant de polarisation (environ 1μA). La sortie de l'amplificateur 40 est reliée aux entrées de commande des générateurs de courant réglable 12a, 12b des deux étages. Ces générateurs 12a, 12b augmentent ou diminuent le courant I2 qu'ils délivrent lorsqu'ils reçoivent un signal de réglage d'alignement Verr positif ou négatif.

Le comparateur 40 est ainsi monté dans une boucle de contre-réaction qui agit sur le second étage 8b pour forcer la tension V2b à son point de sortie 11b à la valeur de consigne Vref. Il agit également sur le premier étage 8a de façon que la valeur moyenne VM de la tension de sortie Vout fournie par le point de sortie 11a soit égale à la tension de consigne Vref. Cette action du comparateur 40 et des générateurs de courant réglable 12a, 12b est indépendante de la valeur commandée du gain g. En réalisant le comparateur 40 en technologie BICMOS, on peut répondre en environ 100 ns à une modification de la tension de consigne Vref de l'ordre d'un volt sans affecter la commande de gain.

Dans l'application particulière du circuit à la mise en forme de signaux de standard D2 MAC, le signal d'entrée Vin est le signal analogique présent en sortie du démodulateur (dans le cas d'une transmission hertzienne), ou de l'interface du câble (dans le cas d'une transmission par câble). Le signal de sortie Vout est adressé à un convertisseur analogique/numérique qui le convertit en vue du traitement par un processeur spécialisé. Ce processeur analyse le signal Vout pour déterminer le signal de commande de gain Vcg1, Vcg2 et la tension de référence Vref à appliquer aux bornes de commande 5, 6, 7 du circuit. Lorsque c'est nécessaire, le processeur fait varier la tension de consigne Vref, et le circuit selon l'invention est capable de s'adapter pratiquement instantanément à cette variation.

Bien qu'on ait décrit l'invention en référence à un exemple de réalisation préféré, on comprendra que cet exemple n'est pas limitatif et que diverses modifications peuvent lui être apportées sans sortir du cadre de l'invention.

## Revendications

1.  Circuit amplificateur vidéo à commande de gain et d'alignement, pour transformer un signal d'entrée (Vin) en un signal de sortie (Vout) ayant une valeur moyenne égale à une tension de consigne (Vref) et des variations amplifiées par rapport aux variations du signal d'entrée (Vin) avec un gain (g) commandé par un signal de commande de gain (Vcg1, Vcg2), caractérisé en ce qu'il comprend un premier étage (8a) et un second étage (8b) sensiblement identique au premier étage, en ce que chacun de ces deux étages (8a, 8b) comprend respectivement un point d'entrée (10a, 10b) et un point de sortie (11a, 11b) et est agencé pour produire à son point de sortie respectif (11a, 11b) une tension (V2a, V2b) ayant une valeur moyenne réglable et des variations amplifiées par rapport aux variations de la tension (V1a, V1b) à son point d'entrée respectif (10a, 10b) avec le gain (g) commandé par le signal de commande de gain (Vcg1, Vcg2), en ce que le point d'entrée (10a) du premier étage (8a) est relié à un condensateur de découplage (30) recevant le signal d'entrée (Vin), en ce que le point de sortie (11a) du premier étage (8a) fournit le signal de sortie du circuit (Vout), et en ce que le circuit comprend en outre un comparateur (40) ayant une entrée reliée au point de sortie (11b) du second étage (8b) et une entrée recevant la tension de consigne (Vref), ce comparateur (40) répondant à un écart entre la tension de consigne (Vref) et la tension (V2b) au point de sortie (11b) du second étage en produisant un signal de réglage d'alignement (Verr) qui est adressé aux deux étages (8a, 8b) pour modifier identiquement la valeur moyenne de la tension aux points de sortie (11a, 11b) des deux étages, de manière à rendre la tension (V2b) au point de sortie (11b) du second étage (8b) égale à la tension de consigne (Vref).

2.  Circuit conforme à la revendication 1, caractérisé en ce que chacun des deux étages (8a, 8b) comprend des moyens de conversion tension/courant pour transformer la tension (V1a, V1b) au point d'entrée respectif (10a, 10b) en un courant (I3a, I3b) ayant des variations proportionnelles aux variations de la tension (V1a, V1b) au point d'entrée (10a, 10b), un générateur de courant réglable (12a, 12b), et des moyens de multiplication de courant dont l'entrée (16a, 16b) reçoit une combinaison (Iea, Ieb) du courant (I3a, I3b) produit par les moyens de conversion tension/courant et du courant (I2) produit par le générateur de courant réglable (12a, 12b) et qui multiplient cette combinaison de courants (Iea, Ieb) par un facteur (k) imposé par le signal de commande de gain (Vcg1, Vcg2), le point de sortie (11a, 11b) de chacun des étages (8a, 8b) étant disposé pour être à une tension (V2a, V2b) dépendant linéairement du courant (Ica, Icb) produit par les moyens de multiplication de courant respectifs.

3.  Circuit conforme à la revendication 2, caractérisé en ce que les moyens de conversion tension/courant de chaque étage (8a, 8b) comprennent respectivement une résistance (13a, 13b) montée entre le point d'entrée (10a, 10b) et une borne de masse (1), une résistance (14a, 14b) montée entre le point d'entrée (10a, 10b) et une borne d'alimentation (2) du circuit, et une résistance (15a, 15b) ayant une extrémité reliée à l'entrée (16a, 16b) des moyens de multiplication de courant et une autre extrémité reliée au point d'entrée (10a, 10b) par l'intermédiaire d'un tampon d'isolement.

4.  Circuit conforme à la revendication 3, caractérisé en ce que le tampon d'isolement comprend un transistor bipolaire (18a, 18b) monté en émetteur suiveur.

5.  Circuit conforme à l'une des revendications 2 à 4, caractérisé en ce que les moyens de multiplication de courant de chaque étage (8a, 8b) comprennent deux transistors bipolaires identiques (20a et 21a, 20b et 21b) ayant leurs émetteurs respectifs reliés conjointement à l'entrée (16a, 16b) des moyens de multiplication de courant, et deux résistances identiques (22a et 23a, 22b et 23b) reliées respectivement aux collecteurs des deux transistors bipolaires (20a et 21a, 20b et 21b), le signal de commande de gain comprenant deux tensions (Vcg1, Vcg2) respectivement appliquées aux bases des deux transistors bipolaires (20a et 21a, 20b et 21b).

6.  Circuit conforme à la revendication 5, caractérisé en ce que le point de sortie (11a, 11b) de chaque étage (8a, 8b) est relié au collecteur de l'un des transistors bipolaires (20a, 20b) des moyens de multiplication de courant respectifs.

7.  Circuit conforme à l'une des revendications 1 à 6, caractérisé en ce que le comparateur comprend un amplificateur à fort gain, faible consommation à réponse rapide (40).

8. Circuit conforme à la revendication 7, caractérisé en ce que l'amplificateur à fort gain (40) est réalisé en technologie BICMOS.

**Patentansprüche**

1. Videoverstärkerschaltkreis mit Vorgabe von Gain und Alignement, um ein Eingangssignal (Vin) in ein Ausgangssignal (Vout) umzuwandeln, das einen mittleren Wert hat, der gleich einer Vorgabespannung (Vref) ist, und Variationen, die in bezug auf Variationen des Eingangssignals (Vin) mit einem Gain (g) verstärkt sind, der durch ein Signal zur Vorgabe des Gains (Vcgl, Vcg2) vcrgegeben ist, dadurch gekennzeichnet, daß

er eine erste Stufe (8a) und eine zweite Stufe (8b), die im wesentlichen identisch zur ersten Stufe ist, umfaßt, daß jede der zwei Stufen (8a, 8b) jeweils einen Eingangspunkt (10a, 10b) und einen Ausgangspunkt (11a, 11b) umfaßt und so ausgelegt ist, daß sie an ihrem jeweiligen Ausgangspunkt (11a, 11b) eine Spannung (V2a, V2b) ausgeben kann, die einen regelbaren mittleren Wert, und Variationen hat, die in bezug auf Variationen der Spannung (Vla, Vlb) an ihrem jeweiligen Eingangspunkt (10a, 10b) mit dem Gain (g) verstärkt sind, der durch das Signal zur Vorgabe des Gains (Vcg1, Vcg2) vorgegeben ist, daß der Eingangspunkt 10a der ersten Stufe 8a mit einem Koppelkondensator (30) verbunden ist, der das Eingangssignal (Vin) einliest, daß der Ausgangspunkt 11a der ersten Stufe (8a) das Ausgangssignal des Schaltkreises (Vout) ausgibt, und daß der Schaltkreis außerdem einen Komparator (40) umfaßt, der einen Eingang aufweist, der mit dem Ausgangspunkt (11b) der zweiten Stufe (8b) verbunden ist, und einen Eingang aufweist, über den die Vorgabespannung (Vref) eingelesen wird, wobei der Komparator (40) auf eine Aufweichung zwischen der Vorgabespannung (Vref) und der Spannung (V2b) am Ausgangspunkt (llb) der zweiten Stufe reagiert, indem er ein Signal zur Regelung des Alignements (Verr) erzeugt, das an die zwei Stufen (8a, 8b) adressiert ist, um auf identische Art und Weise den mittleren Wert der Spannung an den Ausgangspunkten (11a, 11b) der zwei Stufen derart zu verändern, daß die Spannung (V2b) am Ausgangspunkt (11b) der zweiten Stufe (8b) gleich der Vorgabespannung (Vref) wird.

2. Schaltkreis nach Anspruch 1, dadurch gekennzeichnet, daß jede der zwei Stufen (8a, 8b) Mittel zum Umwandeln von Spannung/Strom zum Transformieren der Spannung (V1a, V1b) am jeweiligen Eingangspunkt (10a, 10b) in einen Strom (I3a, I3b) mit Variationen, die proportional zu Variationen der Spannung (V1a, V1b) am Eingangspunkt (10a, 10b), einen regelbaren Stromgenerator (12a, 12b) und Mittel zum Stromverstärken umfaßt, deren Eingang (16a, 16b) eine Kombination (Iea, Ieb) des Stroms (I3a, I3b), der durch die Mittel zum Umwandeln von Spannung/Strom erzeugt wurde, und von Strom (I2) einliest, der durch den regelbaren Stromgenerator (12a, 12b) erzeugt wurde, und der diese Kombination aus den Strömen (Iea, Ieb) mit einem Faktor (k) multipliziert, der durch das Signal zur Vorgabe des Gains (Vcg1, Vcg2) vorgegeben ist, wobei der Ausgangspunkt (11a, 11b) jeder der Stufen (8a, 8b) so ausgelegt ist, daß er auf einer Spannung (V2a, V2b) liegen kann, die linear von dem Strom (Ica, Icb) abhängt, der durch die jeweiligen Mittel zum Stromverstärken erzeugt wurde.

3. Schaltkreis nach Anspruch 2, dadurch gekennzeichnet, daß die Mittel zum Umwandeln von Spannung/Strom von jeder Stufe (8a, 8b) jeweils einen Widerstand (13a, 13b) umfassen, der zwischen den Eingangspunkt (10a, 10b) und einen Masseanschluß (1) geschaltet ist, einen Widerstand (14a, 14b) umfassen, der zwischen den Eingangspunkt (10a, 10b) und einen Versorgungsanschluß (2) des Schaltkreises geschaltet ist, und einen Widerstand (15a, 15b) umfassen, der ein Ende hat, das mit dem Eingang (16a, 16b) der Mittel zum Stromverstärken verbunden ist, und ein anderes Ende, das mit dem Eingangspunkt (10a, 10b) über einen Zwischenisolator verbunden ist.

4. Schaltkreis nach Anspruch 3, dadurch gekennzeichnet, daß der Zwischenisolator einen bipolaren Transistor (18a, 18b) umfaßt, der als Emitterfolger geschaltet ist.

5. Schaltkreis nach einem der Ansprüche 2 bis 4, dadurch gekennzeichnet, daß die Mittel zum Stromverstärken jeder Stufe (8a, 8b) zwei identische Bipolartransistoren (20a und 21a, 20b und 21b), deren jeweiliger Emitter gemeinsam mit dem Eingang (16a, 16b) der Mittel zum Stromverstärken verbunden ist, und zwei identische Widerstände (22a und 23a, 22b und 23b) umfassen, die jeweils mit den Kollektoren der zwei Bipolartransistoren (20a und 21b, 20b und 21b) verbunden sind, wobei das Signal zur Vorgabe des Gains zwei Spannungen (Vcg1, Vcg2) umfaßt, die jeweils an den Basen der zwei Bipolartransistoren (20a und 21 a, 20b und 21b) anliegen.

6. Schaltkreis nach Anspruch 5, dadurch gekennzeichnet, daß der Ausgangspunkt (11a, 11b) jeder Stufe (8a, 8b) mit dem Kollektor des einen der Bipolartransistoren (201, 20b) der jeweiligen Mittel zum Stromverstärken verbunden ist.

7. Schaltkreis nach einem der Ansprüche 1 bis 6, dadurch gekennzeichnet, daß der Komparator einen Verstärker mit hohem Gain, geringer Verlustleistung und hoher Ansprechgeschwindigkeit (40) umfaßt.

8. Schaltkreis nach Anspruch 7, dadurch gekennzeichnet, daß der Verstärker mit hohem Gain (40) in BICMOS-Technologie hergestellt ist.

**Claims**

1. Video amplifier circuit with gain and alignment control, for converting an input signal (Vin) into an output signal (Vout) having a mean value equal to a reference voltage (Vref) and variations amplified with respect to the variations in the input signal (Vin) with a gain (g) controlled by a gain control signal (Vcg1, Vcg2), characterised in that it comprises a first stage (8a) and a second stage (8b) substantially identical to the first stage, in that each of these two stages (8a, 8b) comprises respectively an input point (10a, 10b) and an output point (11a, 11b) and is arranged to produce, at its respective output point (11a, 11b), a voltage (V2a, V2b) having an adjustable mean value and variations amplified with respect to the variations in the voltage (V1a, V1b) at its respective input point (10a, 10b) with the gain (g) controlled by the gain control signal (Vcg1, Vcg2), in that the input point (10a) of the first stage (8a) is connected to a decoupling capacitor (30) receiving the input signal (Vin), in that the output point (11a) of the first stage (8a) supplies the circuit output signal (Vout), and in that the circuit also comprises a comparator (40) having an input connected to the output point (11b) of the second stage (8b) and an input receiving the reference voltage (Vref), this comparator (40) responding to a difference between the reference voltage (Vref) and the voltage (V2b) at the output (11b) point of the second stage by producing an alignment adjustment signal (Verr) which is sent to the two stages (8a, 8b) in order to modify identically the mean value of the voltage at the output points (11a, 11b) of the two stages , so as to make the voltage (V2b) at the output point (11b) of the second stage (8b) equal to the reference voltage (Vref).

2. Circuit according to Claim 1, characterised in that each of the two stages (8a, 8b) comprises voltage/current conversion means for transforming the voltage (V1a, V1b) at the respective input point (10a, 10b) into a current (I3a, I3b) having variations proportional to the variations in the voltage (V1a, V1b) at the input point (10a, 10b), an adjustable current generator (12a, 12b), and current multiplication means whose input (16a, 16b) receives a combination (Iea, Ieb) of the current (I3a, I3b) produced by the voltage/current conversion means and of the current (I2) produced by the adjustable current generator (12a, 12b) and which multiply this combination of currents (Iea, Ieb) by a factor (k) imposed by the gain control signal (Vcg1, Vcg2), the output point (11a, 11b) of each of the stages (8a, 8b) being disposed so as to be at a voltage (V2a, V2b) depending linearly on the current (Ica, Icb) produced by the respective current multiplication means.

3. Circuit according to Claim 2, characterised in that the voltage/current conversion means of each stage (8a, 8b) comprise respectively a resistor (13a, 13b) connected between the input point (10a, 10b) and an earth terminal (1), a resistor (14a, 14b) connected between the input point (10a, 10b) and a supply terminal (2) of the circuit, and a resistor (15a, 15b) having one end connected to the input (16a, 16b) of the current multiplication means and another end connected to the input point (10a, 10b) of the stage by means of an isolating buffer.

4. Circuit according to Claim 3, characterised in that the isolating buffer comprises a bipolar transistor (18a, 18b) connected as an emitter follower.

5. Circuit according to one of Claims 2 to 4, characterised in that the current multiplication means of each stage (8a, 8b) comprise two identical bipolar transistors (20a and 21a, 20b and 21b) having their respective emitters connected conjointly to the input (16a, 16b) of the current multiplication means, and two identical resistors (22a and 23a, 22b and 23b) connected respectively to the collectors of the two bipolar transistors (20a and 21a, 20b and 21b), the gain control signal comprising two voltages (Vcg1, Vcg2) respectively applied to the bases of the two bipolar transistors (20a and 21a, 20b and 21b).

6. Circuit according to Claim 5, characterised in that the output point (11a, 11b) of each stage (8a, 8b) is connected to the collector of one of the bipolar transistors (20a, 20b) of the respective current multiplication means.

7. Circuit according to one of Claims 1 to 6, characterised in that the comparator comprises a high-gain, low-consumption and rapid-response amplifier (40).

8. Circuit according to Claim 7, characterised in that the high-gain amplifier (40) is produced in BICMOS technology.